# EUROPEAN PATENT SPECIFICATION

(11) **EP 2 839 516 B1**
(45) Date of publication and mention of the grant of the patent: **06.01.2016**
(21) Application number: 13725795.2
(22) Date of filing: 16.04.2013
(51) Int. Cl.: H01L 31/052, F24J 2/46

(54) **A SYSTEM FOR PREVENTING CONDENSATION PHENOMENA IN A GROUP OF CONCENTRATION PHOTOVOLTAIC PANELS**
SYSTEM ZUR VERHINDERUNG VON KONDENSATIONSPHÄNOMENEN IN EINER GRUPPE PHOTOVOLTAISCHER KONZENTRATIONSTAFELN
SYSTÈME POUR EMPÊCHER DES PHÉNOMÈNES DE CONDENSATION DANS UN GROUPE DE PANNEAUX PHOTOVOLTAÏQUES À CONCENTRATION

(30) Priority: 18.04.2012 IT BO20120215
(43) Date of publication of application: 25.02.2015
(73) Proprietor: Gpiii S.r.l., 40014 Crevalcore (Bologna) (IT)
(72) Inventor: PASSERINI, Gianluca, I-40014 Crevalcore (bologna) (IT)
(74) Representative: Dall'Olio, Christian
(86) International application number: PCT/IB2013/053010
(87) International publication number: WO 2013/156928

(56) References cited:
- WO-A1-2012/012919
- US-A- 4 045 246
- US-A1- 2007 193 620
- US-A1- 2009 188 560

## Description

### FIELD OF INVENTION

The present invention relates to the technical sector relating to concentration photovoltaic panels, with particular reference to systems for the prevention of condensation phenomena.

### DESCRIPTION OF PRIOR ART

Concentration photovoltaic panels are subdivided into types having high (HCPV) and low (LCPV) concentration substantially as a function of the ratio between the surfaces of captured solar rays and the surface of the photovoltaic cell, which is commonly known as the number of suns.

US 40 45246 discloses a concentration photovoltaic panel.

For both types it is necessary to include a tracking system able to automatically enable, instant-by-instant, the optimal orientation of the optical concentration system with respect to the sun.

Generally groups of predetermined potential are included, which comprise a plurality of panels suitable synchronised with one another and electrically cabled, the groups being mounted on the tracking structures by means of standard-type alignment procedures.

Each panel comprises a superiorly-open body for containing a plurality of photovoltaic modules of the above-indicated type, a transparent closing surface and a pair of heads for lateral closure thereof.

Each panel is supported, for example rotatably, by a pair of box bars that are parallel to one another, by means of fixed pins at the heads.

The pins are made hollow, such as to enable extraction of the electric cabling, and the housing internally of the box bars.

A particularly serious drawback involving concentration photovoltaic panels consists in the formation of condensation internally of the body in which the silicon photovoltaic cells are housed.

The condensation phenomena become particularly problematic in environmental conditions of low temperature and/or high damp factor, where they can damage and/or compromise the integrity and the correct functioning of the photovoltaic cells.

At present some systems for the reduction of the condensation phenomena are known, briefly summarised in the following.

A first system includes the sealing of the body, the upper closing surface and the lateral closing heads.

This system has been revealed to be totally unrealisable for the sealing sections subjected to the atmospheric conditions.

A second system includes realising slits in the housing body of the photovoltaic cells so as to facilitate natural ventilation.

This system leads to an increase in production costs of the body, apart from being poorly effective in extreme temperature and damp conditions.

### SUMMARY OF THE INVENTION

The aim of the present invention is to provide a system for prevention of condensation phenomena in concentration photovoltaic panels, able to safeguard the integrity of the photovoltaic cells in working conditions which can facilitate the presence of the condensation phenomena.

A further aim of the invention is to provide a system having a relatively limited cost, able to be applied also to pre-existing plants, which has the distinction of having particularly modest costs for initial installation and maintenance.

The above aims are attained with a system for prevention of condensation phenomena in a group of concentration photovoltaic panels; with each photovoltaic panel comprising: a closed longitudinal body which exhibits a pair of opposite heads and a longitudinal surface enabling passage of solar rays internally of the body; a plurality of photovoltaic cells contained in the body and destined to be interested by solar rays penetrating into the body; each photovoltaic panel being bilaterally supported by an oppositely-located pair of box bars belonging to a support frame of the group, by means of sleeves interesting the heads of the body and the box bars; the box bars identifying first internal channels provided for housing at least an electric cabling of each photovoltaic panel; the sleeves identifying second internal channels provided for housing at least the electric cabling of the associated photovoltaic panel; characterised in that it comprises: ventilator means able to generate an air flow which is forced to circulate in a predetermined pathway which interests the first internal channels of the box bars, the second internal channels of the sleeves of each photovoltaic panel, and the closed bodies of each photovoltaic panel; at least an outlet section through which the air flow can open to an outside; the air flow being able to prevent formation of condensation phenomena internally of the bodies of each panel.

In special embodiments the system for prevention of condensation phenomena which is the object of the invention comprises one or more of the following characteristics, considered singly or in combination:
- an outlet section of the air flow located at a box bar;
- the outlet section of the air flow located at a head of a box bar;
- the ventilator means positioned at a box bar;
- the ventilator means located at a head of a box bar;
- the ventilator means are provided at a first box bar, and the outlet section of the flow of air is located at the other box body;
- the ventilator means are provided at a first head of the first box bar and the outlet section of the air flow is located at a head of the other box bar;
- the ventilator means are located in proximity of a first head photovoltaic panel, and the second outlet of the air flow is located in proximity of a second head photovoltaic panel, opposite the first head panel;
- heating means are provided, preferably associated to the ventilator means, enabling generation of an air flow at a variable temperature;
- dryer means are provided, preferably associated to the ventilator means, which dryer means enable generation of a variable-humidity air flow.

### BRIEF DESCRIPTION OF THE DRAWINGS

The characteristics of the invention will be explained in the following in which some preferred but not exclusive embodiments are described by way of non-exclusive example, with reference to the accompanying tables of drawings in which:

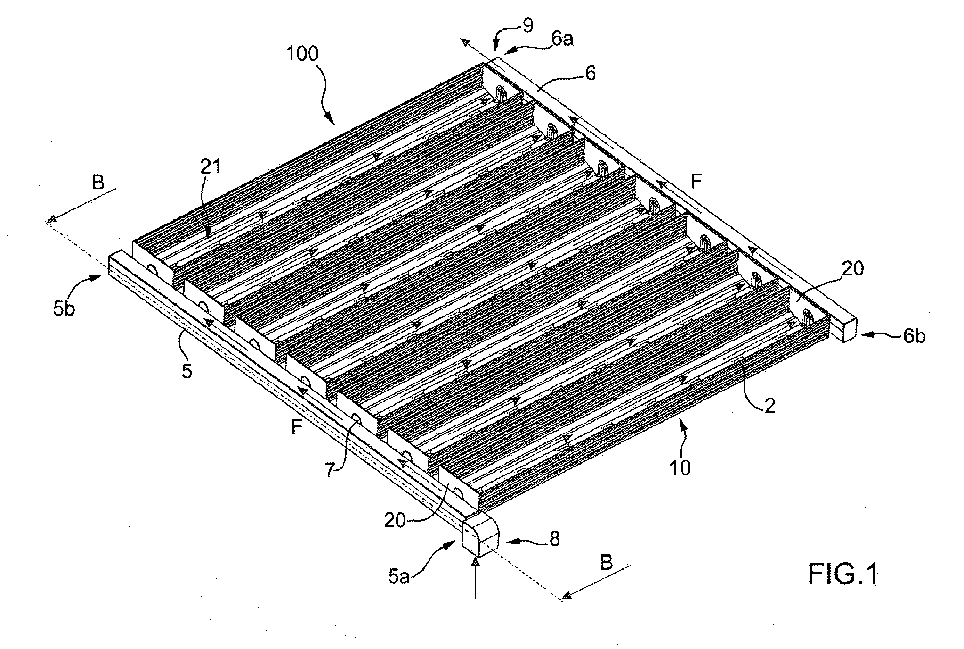

- figure 1 illustrates a perspective view of a group of photovoltaic panels provided with the disclosed system of prevention of condensation phenomena;

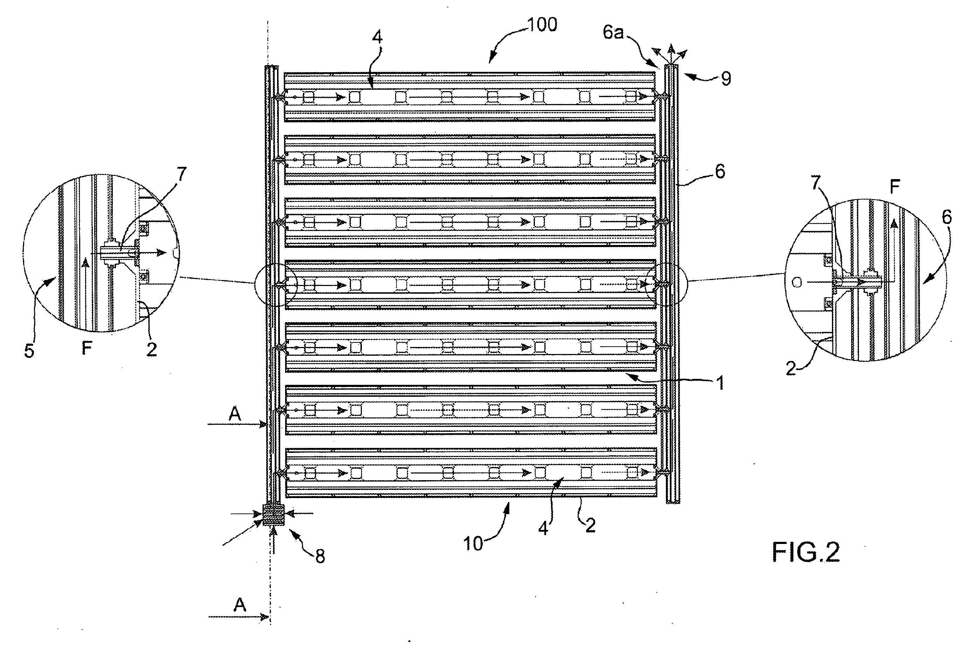

- figure 2 is a view along section B-B indicated in figure 1;

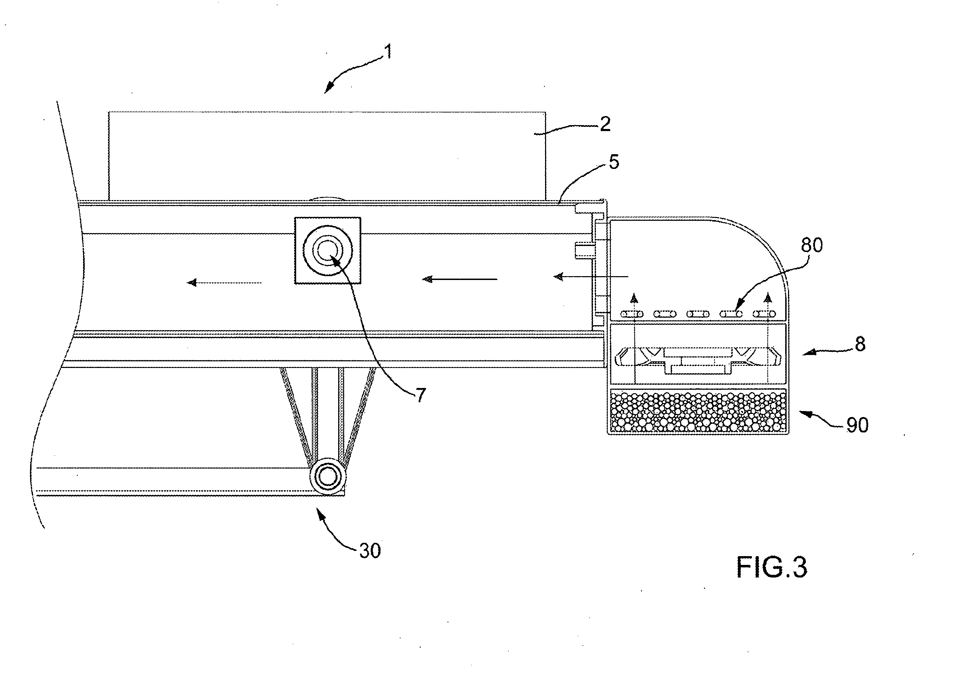

- figure 3 is a view along section A-A indicated in figure 2.

### DESCRIPTION OF PREFERRED EMBODIMENTS

With reference to the tables of drawings, general reference numeral 1 denotes a single generic photovoltaic panel of the group of panels to which the system for the prevention of condensation phenomena is applied.

In known ways, each photovoltaic panel 1 comprises a closed longitudinal body 2 which identifies a pair of opposite heads 20 and a longitudinal surface 21, of a transparent type, which enables passage of the solar rays internally of the body 2.

A plurality of photovoltaic cells 4 is contained in the body 2, which cells 4 are destined to be interested by solar rays which penetrate into the body 2 through the transparent surface 21.

In known ways, each photovoltaic panel 1 is bilaterally supported, for example rotatably, by a pair of box bars 5, 6 located opposite, belonging to a support frame 30 of the group, by sleeves 7 which interest the heads 20 of the body 2 and the box bodies 5, 6.

The heads 20 can be realised in a single body with the body 2, or can be made separately and coupled with the remaining portion of the body 2.

The box bars 5, 6 identify first internal channels 50, 60 for housing the electric cable of each photovoltaic panel 1, such that the sleeves 7 identify second internal channels 70 provided with housing the electric cabling of the associated photovoltaic panel 1.

The proposed system for the prevention of the condensation phenomena in concentration photovoltaic panels includes ventilator means 8 able to generate an air flow F which is forced to circulate through a predetermined path which involves the first internal channels 50, 60 of the box bars 5, 6, the second internal channels 70 of the sleeves 7 of each photovoltaic panel 1 and the closed bodies 2 of each photovoltaic panel 1.

The system of the invention further comprises at least an outlet section 9 through which the air flow F generated by the ventilator means 8 can open externally of the group of photovoltaic panels 1.

The air flow F thus generated and conveyed can prevent the formation of condensation phenomena internally of the bodies 2 of each photovoltaic panel 1.

In the accompanying tables of drawings, the ventilators 8 are illustrated at a first head 5a of the first box body 5, while the outlet section 9 of the air flow F has been illustrated at an opposite head 6a of the other box body 6.

In particular the ventilator means 8 are located in proximity of a first head photovoltaic panel 10, and the outlet section 9 of the air flow F in proximity of a second head photovoltaic panel 100, opposite the first head panel 10.

In this way the ventilator means 8 and the outlet section 9 are opposite to one another such as to enable the air flow F to uniformly involve all the photovoltaic panels 1 of the group.

The remaining heads 5b, 6b of the bars 5, 6 are closed by means of caps, such as preferably to enable use of a single outlet section 9 or alternatively use of a plurality of outlet sections 9.

As the content of the tables is provided purely by way of example, it is possible to locate (or not) both the ventilator means 8 and the outlet section 9 of the air flow F at a box bar 5, 6 in any longitudinal position thereof, for example on the half-way line.

In the same way, both the ventilator means 8 and the outlet flow 9 of the air flow F can be located at a head 5a, 6a of a same box bar 5, 6 or at different box bars 5, 6.

In this case the ventilator means 8 and the outlet section 9 can be arranged on opposite heads 5a, 6a (as in the figures) or on adjacent heads 5a, 6a, i.e. both in proximity of the first head photovoltaic panel 10, i.e. the second head photovoltaic panel 100.

In a further embodiment the disclosed system can further comprise heating means 80 which can enable generation of an air flow F at a variable and controlled temperature.

The heating means 80 are preferably associated to ventilator means 8 for a greater compactness of the thermo-ventilating group.

In a further embodiment, the system of the invention can further comprise drying means 90 that can enable generation of an air flow F at a variable and controlled humidity.

The drying means 90 are preferably provided in association with ventilator means 8, for a greater compactness of the drying-ventilating group.

Therefore, apart from the presence of the ventilator means 8, it is also possible to include a combined or separate presence of drying means 90 and heating means 80, while also having a single deriving group for the sake of greater compactness.

From the above description, it is clear that the disclosed system for prevention of condensation phenomena in concentration photovoltaic panels is able to safeguard the integrity of the photovoltaic cells in working conditions which can facilitate the presence of any condensation phenomena.

The system is particularly advantageously applicable on both new groups of photovoltaic panels and on pre-existing group, as it exploits channelling already present and comprised for other aims, for example for housing electric cabling of each photovoltaic panel.

The components used ensure relatively limited production costs and especially significantly limit the costs relating to initial installation and maintenance.

## Claims

1. A system for preventing condensation phenomena in a group of concentration photovoltaic panels; each photovoltaic panel comprising: a closed longitudinal body (2) which exhibits a pair of opposite heads (20) and a longitudinal surface (21) enabling passage of solar rays internally of the body (2); a plurality of photovoltaic cells (4) contained in the body (2) and destined to be interested by solar rays penetrating into the body (2); each photovoltaic panel (1) being bilaterally supported by an oppositely-located pair of box bars (5, 6) belonging to a support frame (30) of the group, by means of sleeves (7) interesting the heads (20) of the body (2) and the box bars (5, 6); the box bars (5, 6) identifying first internal channels (50, 60) provided for housing at least an electric cabling of each photovoltaic panel (1); the sleeves (7) identifying second internal channels (70) provided for housing at least the electric cabling of the associated photovoltaic panel (1); **characterised in that** it comprises: ventilator means (8) able to generate an air flow (F) which is forced to circulate in a predetermined pathway which interests the first internal channels (50, 60) of the box bars (5, 6), the second internal channels (70) of the sleeves (7) of each photovoltaic panel (1), and the closed bodies (2) of each photovoltaic panel (1); at least an outlet section (9) through which the air flow (F) can open to an outside; the air flow (F) being able to prevent formation of condensation phenomena internally of the bodies (1) of each panel (1).

2. The system of claim 1, **characterised in that** it comprises an outlet section (9) of the air flow (F) located at a box bar (5, 6).

3. The system of claim 2, **characterised in that** it comprises the outlet section (9) of the air flow (F) at a head (5a, 6a) of a box bar (5, 6).

4. The system of one of claims from 1 to 3, **characterised in that** it comprises the ventilator means (8) at a box bar (5, 6).

5. The system of one of claims from 1 to 4, **characterised in that** it comprises the ventilator means (8) at a head (5a, 6a) of a box bar (5, 6).

6. The system of one of claims from 1 to 5, **characterised in that** it comprises the ventilator means (8) at a first box bar (5), and the outlet section (9) of the air flow (F) at the other box bar (6).

7. The system of claim 6, **characterised in that** it comprises the ventilator means (8) at a first head (5a) of the first box bar (5) and the outlet section (9) of the air flow (F) at a head (6a) of the other box bar (6).

8. The system of claim 7, **characterised in that** it comprises the ventilator means (8) in proximity of a first head photovoltaic panel (10), and the second outlet (9) of the air flow (F) in proximity of a second head photovoltaic panel (100), opposite the first head panel (10).

9. The system of one of claims from 1 to 8, **characterised in that** it comprises heating means (80), preferably associated to the ventilator means (8), enabling generation of an air flow (F) at a variable temperature.

10. The system of one of claims from 1 to 9, **characterised in that** it comprises dryer means (90), preferably associated to the ventilator means (8), which dryer means (90) enable generation of a variable-humidity air flow (F).

## Patentansprüche

1. System zur Verhinderung von Kondensationserscheinungen in einer Gruppe von Konzentrator-Photovoltaikmodulen; wobei jedes Photovoltaikmodul (1) Folgendes beinhaltet: ein geschlossenes längliches Gehäuse (2), das ein Paar einander gegenüberliegende Kopfteile (20) und eine längliche Oberfläche (21) aufweist, die den Durchgang von Sonnenstrahlen in das Innere des Gehäuses (2) ermöglicht; mehrere photovoltaische Zellen (4), die in dem Gehäuse (2) enthalten und dafür ausgelegt sind, den in das Gehäuse (2) eintretenden Sonnenstrahlen ausgesetzt zu werden; wobei jedes Photovoltaikmodul (1) beidseitig von einem Paar einander gegenüberliegender kastenförmiger Stäbe (5, 6), die Bestandteil eines Trägerrahmens (30) der Gruppe sind, getragen wird mittels Buchsen (7), die sowohl mit den Kopfteilen (20) des Gehäuses (2) als auch mit den kastenförmigen Stäben (5, 6) in Eingriff stehen; wobei die kastenförmigen Stäbe (5, 6) erste interne Kanäle (50, 60) für die Aufnahme von zumindest einer elektrischen Verkabelung jedes Photovoltaikmoduls (1) bilden; wobei die Buchsen (7) zweite interne Kanäle (70) für die Aufnahme von zumindest der elektrischen Verkabelung des zugehörigen Photovoltaikmoduls (1) bilden; **dadurch gekennzeichnet, dass** es Folgendes beinhaltet: Ventilatormittel (8), die in der Lage sind, einen Luftstrom (F) zu erzeugen, der entlang eines vorbestimmten Zirkulationsweges zwangsumgewälzt wird, der durch die ersten internen Kanäle (50, 60) der kastenförmigen Stäbe (5, 6), die zweiten internen Kanäle (70) der Buchsen (7) jedes Photovoltaikmoduls (1) und die geschlossenen Gehäuse (2) jedes Photovoltaikmoduls (1) führt; zumindest einen Auslassabschnitt (9), durch den der Luftstrom (F) nach außen münden kann; wobei dieser Luftstrom (F) in der Lage ist, die Entstehung von Kondensationserscheinungen im Innern der Gehäuse (2) jedes Moduls (1) zu verhindern.

2. System nach Anspruch 1, **dadurch gekennzeichnet, dass** es einen Auslassabschnitt (9) für den Luftstrom (F) aufweist, der an einem kastenförmigen Stab (5, 6) angeordnet ist.

3. System nach Anspruch 2, **dadurch gekennzeichnet, dass** es den Auslassabschnitt (9) für den Luftstrom (F) an einem Kopfteil (5a, 6a) eines kastenförmigen Stabes (5, 6) beinhaltet.

4. System nach einem der Ansprüche von 1 bis 3, **dadurch gekennzeichnet, dass** es die Ventilatormittel (8) an einem kastenförmigen Stab (5, 6) beinhaltet.

5. System nach einem der Ansprüche von 1 bis 4, **dadurch gekennzeichnet, dass** es die Ventilatormittel (8) an einem Kopfteil (5a, 6a) eines kastenförmigen Stabes (5, 6) beinhaltet.

6. System nach einem der Ansprüche von 1 bis 5, **dadurch gekennzeichnet, dass** es die Ventilatormittel (8) an einem ersten kastenförmigen Stab (5) und den Auslassabschnitt (9) für den Luftstrom (F) an dem anderen kastenförmigen Stab (6) beinhaltet.

7. System nach Anspruch 6, **dadurch gekennzeichnet, dass** es die Ventilatormittel (8) an einem ersten Kopfteil (5a) des ersten kastenförmigen Stabes (5) und den Auslassabschnitt (9) für den Luftstrom (F) an einem Kopfteil (6a) des anderen kastenförmigen Stabes (6) beinhaltet.

8. System nach Anspruch 7, **dadurch gekennzeichnet, dass** es die Ventilatormittel (8) an einem ersten stirnseitigen Photovoltaikmodul (10) beinhaltet, und den Auslassabschnitt (9) für den Luftstrom (F) an einem dem ersten stirnseitigen Modul (10) gegenüberliegenden zweiten stirnseitigen Photovoltaikmodul (100) beinhaltet.

9. System nach einem der Ansprüche von 1 bis 8, **dadurch gekennzeichnet, dass** es Heizmittel (80) beinhaltet, die vorzugsweise mit den Ventilatormitteln (8) verbunden sind und die Erzeugung eines Luftstroms (F) mit variabler Temperatur ermöglichen.

10. System nach einem der Ansprüche von 1 bis 9, **dadurch gekennzeichnet, dass** es Trocknermittel (90) beinhaltet, die vorzugsweise mit den Ventilatormitteln (8) verbunden sind, wobei diese Trocknermittel (90) die Erzeugung eines Luftstroms (F) mit variabler Feuchtigkeit ermöglichen.

## Revendications

1. Un système pour empêcher des phénomènes de condensation dans un groupe de panneaux photovoltaïques à concentration; chaque panneau photovoltaïque (1) comprenant: un corps longitudinal fermé (2) qui présente une paire de têtes opposées (20) et une surface longitudinale (21) permettant le passage des rayons solaires à l'intérieur du corps (2); une pluralité de cellules photovoltaïques (4) contenues dans le corps (2) et destinées à être intéressées par les rayons solaires qui pénètrent dans le corps (2) ; chaque panneau photovoltaïque (1) étant bilatéralement supporté par une paire de barres en caisson (5, 6) opposées appartenant à un châssis (30) de support du groupe, au moyen de manchons (7) assujettissant les têtes (20) du corps (2) et les barres en caisson (5, 6) ; les barres en caisson (5, 6) identifiant des premiers canaux intérieurs (50, 60) prévus pour loger au moins un câblage électrique de chaque panneau photovoltaïque (1) ; les manchons (7) identifiant des deuxièmes canaux intérieurs (70) prévus pour loger au moins le câblage électrique du panneau photovoltaïque (1) associé ; **caractérisé en ce qu'**il comprend : des moyens ventilateurs (8) destinés à générer un flux d'air (F) qui circule de façon forcée dans un parcours prédéfini qui intéresse les premiers canaux intérieurs (50, 60) des barres en caisson (5, 6), les deuxièmes canaux intérieurs (70) des manchons (7) de chaque panneau photovoltaïque (1), et les corps fermés (2) de chaque panneau photovoltaïque (1) ; au moins une section de sortie (9) à travers laquelle le flux d'air (F) peut déboucher à l'extérieur ; le flux d'air (F) étant destiné à empêcher la formation de phénomènes de condensation à l'intérieur des corps (2) de chaque panneau (1).

2. Le système selon la revendication 1, **caractérisé en ce qu'**il comprend une section (9) de sortie du flux d'air (F) située au niveau d'une barre en caisson (5, 6).

3. Le système selon la revendication 2, **caractérisé en ce qu'**il comprend la section (9) de sortie du flux d'air (F) au niveau d'une tête (5a, 6a) d'une barre en caisson (5, 6).

4. Le système selon l'une des revendications de 1 à 3, **caractérisé en ce qu'**il comprend les moyens ventilateurs (8) au niveau d'une barre en caisson (5, 6).

5. Le système selon une des revendications de 1 à 4, **caractérisé en ce qu'**il comprend les moyens ventilateurs (8) au niveau d'une tête (5a, 6a) d'une barre en caisson (5, 6).

6. Le système selon une des revendications de 1 à 5, **caractérisé en ce qu'**il comprend les moyens ventilateurs (8) au niveau d'une première barre en caisson (5), et la section (9) de sortie du flux d'air (F) au niveau de l'autre barre en caisson (6).

7. Le système selon la revendication 6, **caractérisé en ce qu'**il comprend les moyens ventilateurs (8) au niveau d'une première tête (5a) de la première barre en caisson (5) et la section (9) de sortie du flux d'air (F) au niveau d'une tête (6a) de l'autre barre en caisson (6).

8. Le système selon la revendication 7, **caractérisé en ce qu'**il comprend les moyens ventilateurs (8) à proximité d'un premier panneau photovoltaïque de tête (10), et la section (9) de sortie du flux d'air (F) à proximité d'un deuxième panneau photovoltaïque de tête (100), opposé au premier panneau de tête (10).

9. Le système selon une des revendications de 1 à 8, **caractérisé en ce qu'**il comprend des moyens de chauffage (80), associés de préférence aux moyens ventilateurs (8), permettant la génération d'un flux d'air (F) à une température variable.

10. Le système selon une des revendications de 1 à 9, **caractérisé en ce qu'**il comprend des moyens sécheurs (90), associés de préférence aux moyens ventilateurs (8), lesdits moyens sécheurs (90) permettant la génération d'un flux d'air (F) à humidité variable.
